Europäisches Patentamt

European Patent Office

Office européen des brevets

(19)

(11) Numéro de publication: **0 138 697**
**A2**

# (12) DEMANDE DE BREVET EUROPEEN

(21) Numéro de dépôt: **84402004.0**

(22) Date de dépôt: **05.10.84**

(51) Int. Cl.⁴: **H 05 K 5/06, H 01 R 13/04**

---

(30) Priorité: **10.10.83 FR 8316083**

(43) Date de publication de la demande: **24.04.85**
**Bulletin 85/17**

(84) Etats contractants désignés: **DE FR GB IT NL**

(71) Demandeur: **THOMSON-CSF, 173, Boulevard Haussmann, F-75379 Paris Cedex 08 (FR)**

(72) Inventeur: **Rischmuller, Klaus, THOMSON-CSF SCPI 173, bld Haussmann, F-75379 Paris Cedex 08 (FR)**

(74) Mandataire: **Guérin, Michel et al, THOMSON-CSF SCPI 173, Bld Haussmann, F-75379 Paris Cédex 08 (FR)**

---

(54) **Commutateur double pour onduleurs, encapsulé en boîtier à broches extérieures planes.**

(57) L'invention concerne un commutateur double comprenant deux transistors ou thyristors et deux diodes. Pour faciliter la production sur une seule chaîne de fabrication de deux types de commutateurs destinés à des applications différentes, on prévoit un boîtier à six broches C1, C2, E1, E2, D1, D2 en vis-à-vis deux à deux, pouvant se replier les unes vers les autres selon deux configurations possibles, l'une avec recouvrement des broches pour mettre en court-circuit les couples de deux broches en vis-à-vis et obtenir un boîtier à trois broches, l'autre sans recouvrement pour obtenir un boîtier à six broches séparées.

COMMUTATEUR DOUBLE POUR ONDULEURS, ENCAPSULE EN BOITIER
A BROCHES EXTERIEURES PLANES.

La présente invention concerne un commutateur électronique de puissance encapsulé dans un boîtier de matière plastique et destiné notamment à être utilisé comme organe de commutation de puissance dans un onduleur, cet organe étant appelé ci-après commutateur double parce qu'il comporte essentiellement deux éléments de commutation commandés (transistors ou thyristors) et deux diodes dites "de roue libre".

On cherche à résoudre le problème très concret de la fabrication industrielle la plus économique possible d'un commutateur double qui puisse répondre aux besoins des utilisateurs (fabricants d'onduleurs par exemple) même lorsque ces besoins varient dans le temps : par exemple, on veut pouvoir vendre, en ne modifiant presque pas la chaîne de fabrication, un lot de commutateurs adaptés à des onduleurs de bas de gamme, puis un lot de commutateurs adaptés à des onduleurs de haut de gamme. Or, le montage électrique du commutateur dans l'onduleur dépend évidemment du type d'onduleur choisi ; en particulier, un commutateur conçu pour le bas de gamme peut ne comporter, outre les broches de commande de commutation, que trois broches extérieures de puissance représentant respectivement un point milieu et deux bornes de sortie de transistors de puissance, alors qu'un onduleur de haut de gamme pourra comporter six broches extérieures : quatre broches pour l'accès à l'émetteur et au collecteur de chacun des transistors et deux broches pour l'accès à l'anode ou à la cathode de deux diodes dites "de roue libre" faisant partie du commutateur.

On conçoit donc qu'a priori les deux types de commutateurs doubles doivent être fabriqués sur des chaînes de fabrication très différentes l'une de l'autre.

La présente invention propose une construction de commutateur propre à permettre la fabrication d'un seul type de commutateur convenant aux deux usages, la différenciation s'effectuant à un stade très tardif de la fabrication, permettant

2

notamment le stockage de grandes quantités de commutateurs indifférenciés pouvant très rapidement être terminés en fonction des besoins, pour devenir essentiellement :

- soit des commutateurs à trois broches de puissance pour applications simples,

- soit des commutateurs à six broches de puissance pour applications plus sophistiquées.

Le commutateur selon l'invention est encapsulé dans un boîtier de matière plastique d'où émergent, outre des broches de commande, six broches métalliques planes pour les connexions extérieures de puissance, et ses caractéristiques sont les suivantes :

a) au stade presque final de la fabrication (stade de stockage), la configuration mécanique extérieure du commutateur est la suivante : la surface supérieure du boîtier comporte neuf évidements propres à recevoir et bloquer en rotation chacun un écrou de fixation, ces évidements étant groupés en trois rangées parallèles de trois évidements, deux broches extérieures étant placées en vis-à-vis de part et d'autre de chaque groupe de trois, les broches d'un côté étant disposées dans un plan commun perpendiculaire à la surface supérieure du boîtier et les broches en vis-à-vis de l'autre côté étant disposées dans un autre plan parallèle au premier, les évidements intermédiaires des groupes de trois étant eux-mêmes alignés dans un plan sensiblement médian entre les deux plans parallèles ; la longueur de toutes les broches est telle que, par repliement des broches, l'évidement intermédiaire puisse être totalement recouvert par les broches en vis-à-vis qui l'encadrent ;

b) la configuration électrique intérieure au boîtier est la suivante : un premier élément de commutation commandé (transistor ou thyristor) présente une borne reliée à une première broche extérieure ; la broche en vis-à-vis de celle-ci est connectée à une diode reliée par ailleurs à un deuxième élément de commutation commandé ; le deuxième élément présente une borne reliée à une autre broche extérieure ; la broche en vis-à-vis de celle-ci est reliée à une autre diode reliée par ailleurs au premier élément de commutation ; le premier et le second éléments de commutation présentent enfin chacun une autre borne et ces autres bornes sont reliées respectivement à deux autres broches extérieures en vis-à-vis.

Pour passer de la configuration mécanique intermédiaire de stockage à une configuration finale propre à être commercialisée en fonction des besoins de l'utilisateur, les seules opérations à effectuer sont les suivantes : découpe et perçage des broches extérieures, mise en place des écrous dans ceux des évidements qui devront être utilisés, repliement des broches en vis-à-vis, l'une vers l'autre, au-dessus des évidements qu'elles encadrent.

Les deux configurations principales auxquelles on aboutit alors sont les suivantes :

- configuration avec recouvrement, où deux broches en vis-à-vis recouvrent toutes les deux, l'une sur l'autre, l'évidement central du groupe qu'elles encadrent,

- configuration sans recouvrement, où deux broches en vis-à-vis ne recouvrent chacune que l'évidement le plus proche du groupe qu'elles encadrent.

D'autres caractéristiques et avantages de l'invention apparaîtront à la lecture de la description détaillée qui est faite en référence aux dessins annexés dans lesquels :

- la figure 1 représente la configuration mécanique extérieure du commutateur double selon l'invention, à un stade intermédiaire de fabrication,

- la figure 2 représente la configuration extérieure finale constituant un commutateur à trois bornes,

- la figure 3 représente la configuration extérieure finale constituant un commutateur à six bornes,

- la figure 4 représente la configuration intérieure du commutateur double,

- la figure 5 représente un schéma d'application du commutateur de la figure 2,

- les figures 6 et 7 représentent des schémas d'application du commutateur de la figure 3.

4

Le commutateur double selon l'invention comporte un circuit électrique enfermé dans un boîtier de matière plastique 10 qui est de préférence un bloc rectangulaire fixé sur une embase métallique 12.

De la surface supérieure sensiblement plane 14 du boîtier, émergent six broches de connexion métalliques planes, raccordées au circuit électrique intérieur et destinées à la partie de puissance du circuit. Ces broches sont désignées par les références C1, D1, E1, C2, D2, E2 respectivement.

Au stade presque final de la fabrication, les six broches s'élèvent toutes perpendiculairement au plan de la surface supérieure 14. Elles sont disposées en trois groupes de deux broches se faisant vis-à-vis, la broche E1 étant en vis-à-vis de la broche C2, la broche E2 en vis-à-vis de la broche D2 et la broche C1 en vis-à-vis de la broche D1.

Les broches E1, E2, C1 sont situées dans un même plan (les broches sont planes), plan qui est perpendiculaire à la surface supérieure 14 et qui passe pratiquement par un bord longitudinal 16 du boîtier rectangulaire. Les broches C2, D2, D1 sont également situées dans un même plan, parallèle au premier, et passant pratiquement par un autre bord longitudinal 18 du boîtier.

Les broches définissent donc deux plans parallèles qui sont pratiquement les plans de deux bords longitudinaux du boîtier.

Creusés dans la surface supérieure 14 sont prévus neuf évidements borgnes ou alvéoles, disposés en trois groupes de trois, chaque groupe comprenant trois évidements alignés avec deux broches en vis-à-vis respectives.

Ainsi, les évidements 20, 22, 24 sont alignés entre les broches E1 et C2, les évidements 26, 28, 30 entre les broches E2 et D2, les évidements 32, 34, 36 entre les broches C1 et D1.

Les évidements centraux 22, 28, 34 des trois groupes sont eux-mêmes alignés sensiblement dans un plan médian entre les plans parallèles contenant les broches.

Les évidements non centraux sont aussi de préférence alignés dans des plans parallèles aux plans des broches.

5

Les évidements sont conformés de manière à pouvoir chacun recevoir et bloquer en rotation un écrou. Des écrous seront déposés ultérieurement dans trois ou six des évidements en fonction des besoins.

La hauteur d'émergence des broches au-dessus de la surface 14 est telle que l'on puisse :

- percer un trou à leur extrémité,

- replier deux broches en vis-à-vis l'une sur l'autre,

- obtenir un recouvrement mutuel des trous percés dans les deux broches, ces trous recouvrant eux-mêmes l'évidement central du groupe situé entre ces broches.

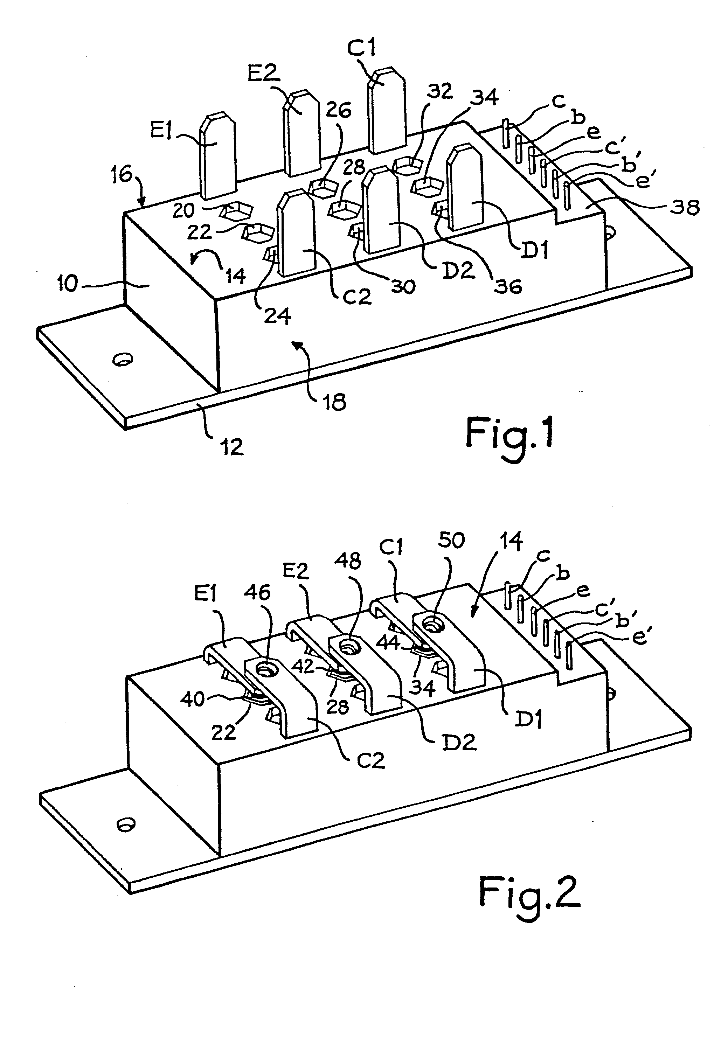

Pour terminer la description extérieure du commutateur dans l'état où il est à la figure 1, état où il peut être stocké, en attendant les commandes des utilisateurs, on peut signaler des broches de commande du commutateur qui ont été représentées au nombre de six et désignées par les références c, b, e, c', b', e'.

Ces broches de commande sont de petite dimension ; elles peuvent être planes ou cylindriques et peuvent être situées par exemple dans un décrochement 38 de la surface supérieure 14 du boîtier.

La figure 2 représente le commutateur double de l'invention, dans une configuration possible qu'il possède en fin de fabrication.

Dans cette configuration, les broches extérieures de puissance ont été percées de trous de passage pour des vis adaptées aux écrous qui doivent se loger dans les évidements ; des écrous 40, 42, 44 ont été mis en place uniquement dans les évidements centraux 22, 28, 34 respectivement. Puis, les broches E1, E2, C1 ont été repliées parallèlement au plan de la surface 14, suffisamment près de cette surface pour empêcher les écrous de sortir des évidements ; enfin les broches C2, D2, D1 de l'autre côté ont été repliées sur les premières. Seuls les trous 46, 48, 50 percés à l'extrémité des broches C2, D2, D1 sont véritablement visibles sur la figure 2, mais il faut comprendre que les trous percés dans deux broches en vis-à-vis ainsi repliées viennent se superposer exactement au-dessus des évidements centraux correspondant à ces broches, de sorte que par mise en place de trois vis, on peut à la fois connecter électriquement entre elles les broches repliées l'une sur l'autre et connecter ces broches à trois conducteurs extérieurs.

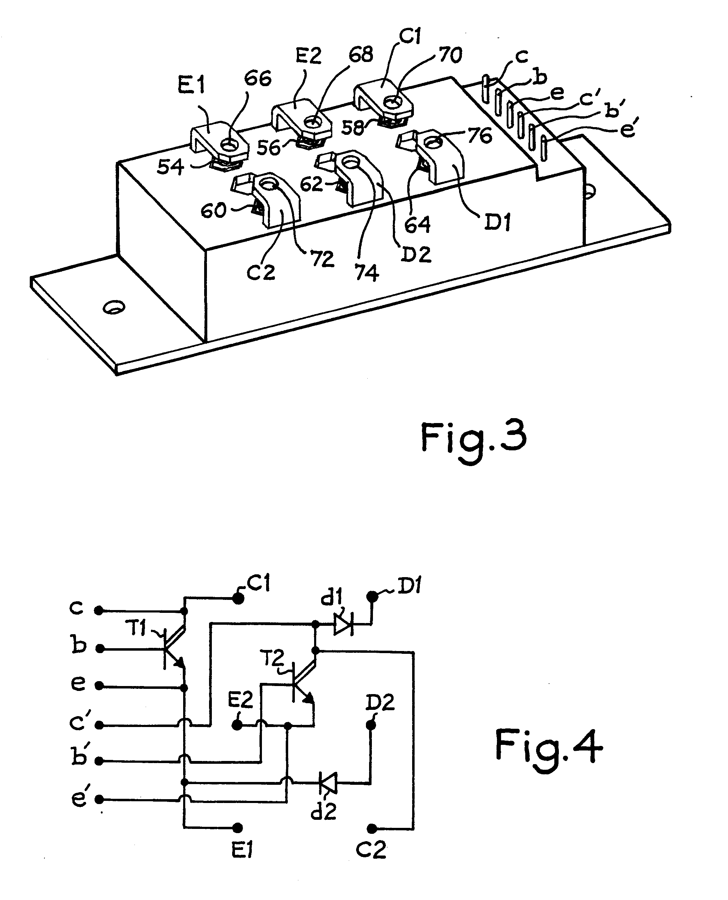

La figure 3 représente une autre configuration possible du commutateur après l'étape finale de fabrication.

Les broches extérieures de puissance ont d'abord été coupées à une longueur suffisamment courte pour qu'une fois repliées elles ne puissent plus se toucher ; ensuite ou simultanément, les broches sont percées à un emplacement tel qu'une fois repliées les trous viendront au-dessus des évidements non centraux. Après mise en place de six écrous 54, 56, 58, 60, 62, 64 dans les évidements non centraux (20, 26, 32, 24, 30, 36 respectivement sur la figure 1), on procède alors au repliement des broches, suffisamment bas pour empêcher les écrous de sortir des évidements. Les trous 66, 68, 70, 72, 74, 76 dans les extrémités des broches viennent alors au-dessus des écrous et permettent la fixation par vis de ces broches sur six conducteurs extérieurs (ou sur d'autres éléments).

La figure 4 représente la configuration électrique interne du commutateur double selon l'invention : les broches extérieures de puissance ont été redésignées par El, E2, Cl, C2, Dl, D2 comme aux figures précédentes et les broches de commande par c, b, e, c', b', e'.

Le circuit comprend deux éléments de commutation commandés Tl et T2 (ici des transistors ou des montages Darlington), et deux diodes dites de roue libre dl et d2.

Le transistor Tl a deux bornes de puissance (collecteur et émetteur) reliées aux broches de puissance Cl et El respectivement ainsi qu'aux broches de commande c et e ; il a une borne de commande (base) reliée à la broche b.

De même, le transistor T2 a deux bornes de puissance (collecteur et émetteur) reliées aux broches de puissance C2 et E2 respectivement ainsi qu'aux broches de commande c' et e' ; il a une borne de commande (base) reliée à la broche b'.

La première diode dl a son anode reliée à la broche C2 et sa cathode à la broche D1 ; la deuxième diode d2 a son anode reliée à la broche D2 et sa cathode à la broche E1.

Cependant, dans une autre configuration possible, on pourrait avoir la diode d1 reliée par sa cathode à la borne D1 et par son anode à la borne E2 et la diode d2 reliée par sa cathode à la borne C1 et par son anode à la borne D2.

Dans tous les cas, il faut retenir que l'une des bornes de puissance (collecteur) du premier transistor (T1) doit être reliée à une broche (C1) en vis-à-vis d'une broche (D1) reliée à une diode (d1) ; que l'autre borne de puissance (émetteur) doit être reliée à une broche (E1) en vis-à-vis d'une broche (C2) reliée à une borne de puissance (collecteur) de l'autre transistor (T2) ; et que l'autre borne de puissance (émetteur) du deuxième transistor (T2) doit être reliée à une broche (E2) en vis-à-vis d'une broche (D2) reliée à l'autre diode (d2).

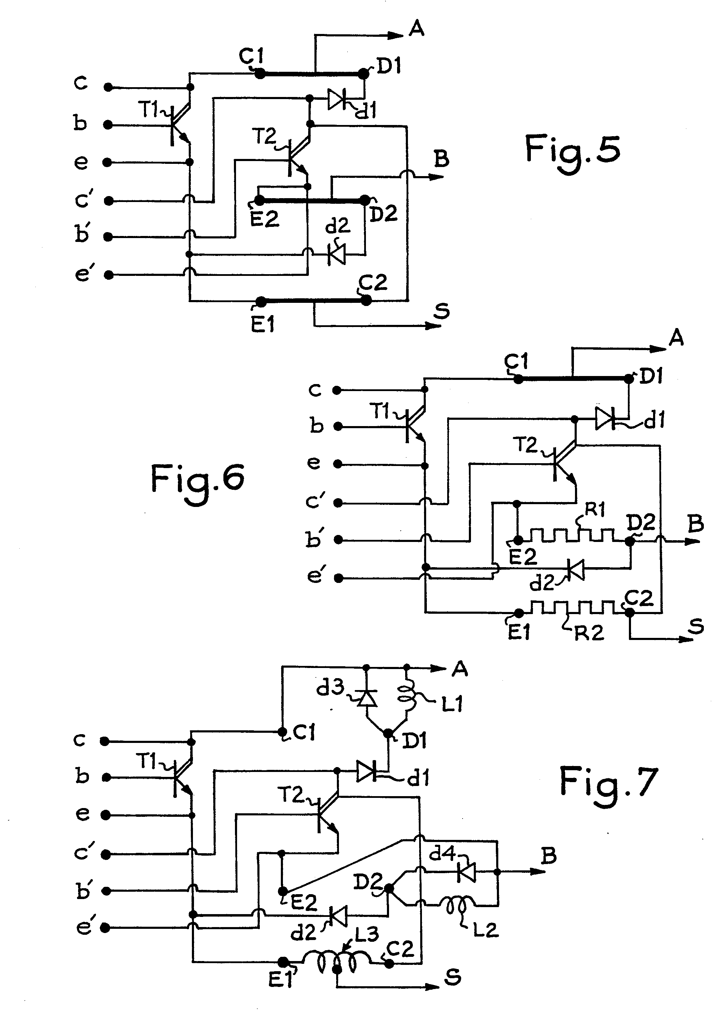

Les figures 5, 6, 7 représentent des schémas d'application possible du commutateur selon l'invention.

Le schéma de la figure 5 correspond à l'utilisation d'un commutateur fabriqué selon la figure 2 : court-circuit entre les bornes E1 et C2 que l'on relie à un conducteur de sortie S, court-circuit entre les bornes E2 et D2 que l'on relie à un conducteur d'alimentation B à un potentiel négatif ou nul, court-circuit entre les bornes C1 et D1 que l'on relie à un conducteur d'alimentation A à un potentiel positif.

Les schémas des figures 6 et 7 correspondent à l'utilisation d'un commutateur selon la figure 3.

A la figure 6, un court-circuit est fait entre les bornes C1 et D1, soit par une barrette conductrice, soit en reliant les deux bornes C1 et D1 à un même conducteur d'alimentation positive A ; une résistance R1 est fixée entre les bornes E2 et D2, la borne D2 étant reliée à un conducteur d'alimentation B à potentiel négatif ou nul ; une autre résistance R2 est fixée entre les bornes E1 et C2, la borne C2 étant par ailleurs reliée à un conducteur de sortie S (relié à une charge).

A la figure 7, pour une application à fréquence plus élevée, on a prévu de relier un conducteur d'alimentation A à la

borne C1, un conducteur B à la borne E2, une diode d3 en parallèle avec une inductance L1 entre la borne D1 et la borne C1, une diode d4 en parallèle avec une inductance L2 entre la bonre E2 et la borne D2, et enfin une inductance L3 entre les bornes E1 et C2 avec une prise intermédiaire sur cette inductance pour la liaison à un conducteur de sortie S.

9

REVENDICATIONS.

1. Commutateur double destiné à être utilisé notamment dans des onduleurs, encapsulé dans un boîtier de matière plastique (10) d'où émergent six broches métalliques planes (E1, E2, C1, C2, D1, D2) pour les connexions extérieures de puissance, caractérisé en ce que :

a) dans un stade intermédiaire de fabrication, la configuration extérieure du commutateur est la suivante : la surface supérieure (14) du boîtier comporte neuf évidements (20, 22, 24, 26, 28, 30, 32, 34, 36), chacun susceptible de recevoir et bloquer en rotation un écrou de fixation, ces évidements étant groupés en trois rangées parallèles de trois évidements, deux broches étant placées en vis-à-vis de chaque côté de chaque groupe de trois, les broches d'un côté (E1, E2, C1) étant disposées dans un plan commun perpendiculaire à la surface supérieure du boîtier et les broches en vis-à-vis (C2, D2, D1) dans un autre plan parallèle au premier, les évidements intermédiaires (22, 28, 34) des groupes de trois étant eux-mêmes alignés dans un plan sensiblement médian entre les deux plans parallèles et la longueur de toutes les broches étant telle que, par repliement, un évidement intermédiaire puisse être totalement recouvert par les broches en vis-à-vis qui l'encadrent, d'où il résulte que les broches peuvent être rabattues, éventuellement après découpe, perçage, et mise en place d'écrous dans certains évidements, au-dessus des évidements du groupe qu'elles encadrent, selon au moins deux configurations, à savoir une configuration avec recouvrement (figure 2) où deux broches en vis-à-vis recouvrent toutes deux l'évidement intermédiaire du groupe qu'elles encadrent, et une configuration sans recouvrement (figure 3) où deux broches en vis-à-vis recouvrent chacune l'évidement le plus proche du groupe qu'elles encadrent,

b) la configuration électrique intérieure au boîtier est la suivante : un premier élément de commutation commandé (T1) présente une borne reliée à une première broche extérieure (C1) ;

10

la broche (D1) en vis-à-vis de celle-ci est reliée à une diode (d1) reliée par ailleurs à un deuxième élément de commutation commandé (T2) ; le deuxième élément (T2) présente une borne reliée à une autre broche extérieure (E2) ; la broche (D2) en vis-à-vis de celle-ci est reliée à une autre diode (d2) reliée par ailleurs au premier élément de commutation (T1) ; le premier élément et le second présentent par ailleurs chacun une autre borne et ces autres bornes sont reliées respectivement à deux autres broches extérieures (E1, C2) en vis-à-vis.

2. Commutateur double selon la revendication 1, caractérisé en ce que, après repliement des broches en vis-à-vis, seuls les évidements intermédiaires (22, 28, 34) de chaque groupe de trois sont pourvus d'un écrou et les broches sont repliées l'une sur l'autre et percées de manière à pouvoir fixer une vis dans l'écrou à travers les perçages des broches.

3. Commutateur double selon la revendication 2, caractérisé en ce que, après repliement des broches en vis-à-vis, seuls les évidements autres que les évidements intermédiaires (22, 28, 34) sont pourvus d'un écrou, et en ce que les broches sont coupées à une longueur telle qu'une fois repliées deux broches en vis-à-vis ne peuvent se toucher, les extrémités des broches étant percées de trous permettant la fixation d'une vis dans les écrous à travers les perçages des broches.

Fig.1

Fig.2

0138697

Fig.3

Fig.4

0138697

3/3

Fig.5

Fig.6

Fig.7